# EUROPEAN PATENT SPECIFICATION

(11) **EP 2 509 243 B1**
(45) Date of publication and mention of the grant of the patent: **04.10.2017**
(21) Application number: 10834497.9
(22) Date of filing: 19.11.2010
(51) Int. Cl.: H04L 1/00, H03M 13/29, H03M 13/35, H03M 13/15, H03M 13/11

(54) **ERROR CORRECTION FOR AN OTPICAL COMMUNICATION SYSTEM SUPPORTING 40 GBIT/S AND 100 GBIT/S CLIENT SIGNALS**
FEHLERKORREKTUR FÜR EIN OPTISCHES KOMMUNIKATIONSSYSTEM WELCHES 40 GBIT/S UND 100 GBIT/S CLIENT-SIGNALE UNTERSTÜTZT
CORRECTION D'ERRUERS POUR UN SYSTÈME DE COMMUNICATION OPTIQUE DES SIGNAUX CLIENT À 40 GBIT/S ET 100 GBIT/S

(30) Priority: 01.12.2009 JP 2009273204
(43) Date of publication of application: 10.10.2012
(73) Proprietor: Mitsubishi Electric Corporation, Tokyo 100-8310 (JP)
(72) Inventor: KUBO, Kazuo, Tokyo 100-8310 (JP); MIZUOCHI, Takashi, Tokyo 100-8310 (JP)
(74) Representative: Pfenning, Meinig & Partner mbB
(86) International application number: PCT/JP2010/070703
(87) International publication number: WO 2011/068045

(56) References cited:
- EP-A1- 2 051 420
- WO-A1-2006/009732
- WO-A1-2008/035769
- WO-A1-2008/087975
- JP-A- 2008 503 937
- WUTH T. ET AL: "Multi-rate (100G/40G/10G) Transport Over Deployed Optical Networks", PROC., IEEE CONFERENCE ON OPTICAL FIBER COMMUNICATION/NATIONAL FIBER OPTIC ENGINEERS CONFERENCE, OFC/NFOEC 2008, 24 February 2008 (2008-02-24), pages 1-9, XP031391404, ISBN: 978-1-55752-856-8
- ITU-T G.709/Y.1331 March 2003, pages 15, 16, 24, 101 - 103
- KOBAYASHI T. ET AL.: 'Soft decision LSI operating at 32 Gsample/s for LDPC FEC-based optical transmission systems' OPTICAL FIBER COMMUNICATION - INCUDES POST DEADLINE PAPERS, 2009. OFC 2009. CONFERENCE ON March 2009, XP031468003
- ITU: "SERIES G: TRANSMISSION SYSTEMS AND MEDIA, DIGITAL SYSTEMS AND NETWORKS Digital sections and digital line system - Optical fibre submarine cable systems Forward error correction for high bit-rate DWDM submarine systems ITU-T Recommendation G.975.1", ITU-T STANDARD IN FORCE (I), INTERNATIONAL TELECOMMUNICATION UNION, GENEVA, CH, no. G.975.1, 1 February 2004 (2004-02-01), pages 1-58, XP002474600,
- MIYATA Y ET AL: "Proposal for frame structure of optical channel transport unit employing LDPC codes for 100 Gb/s FEC", OPTICAL FIBER COMMUNICATION - INCUDES POST DEADLINE PAPERS, 2009. OFC 2009. CONFERENCE ON, IEEE, PISCATAWAY, NJ, USA, 22 March 2009 (2009-03-22), pages 1-3, XP031467599, ISBN: 978-1-4244-2606-5

## Description

### TECHNICAL FIELD

The present invention relates to an error correction method and device applicable to a digital communication device such as an optical communication system.

### BACKGROUND ART

A conventional error correction method and device apply a Reed-Solomon code RS (255, 239) as a forward error correction (FEC) coding scheme (see, for example, Non Patent Literature 1) . Another error correction method that uses a low-density parity-check (LDPC) code as an inner code and an RS code as an outer code has been proposed (see, for example, Patent Literature 1).

The error correction device using the error correction coding scheme disclosed in Non Patent Literature 1 and Patent Literature 1 above is based on the frame configuration having the same information area and the same redundant area irrespective of the transmission rate. For example, the transmission rate for a 10 Gb/s client signal is 10.7 Gb/s using an optical channel transport unit-2 (OTU2) frame, and the transmission rate for a 40 Gb/s client signal is 43.0 Gb/s using an optical channel transport unit-3 (OTU3) frame.

### CITATION LIST

### Patent Literature

[PTL 1] JP 2009-17160 A

### Non Patent Literature

[NPL 1] ITU-T Recommendation G.709/Y.1331 interface for the Optical Transport Network (OTN), Annex A, ITU-T Rec.G.709/Y.1331 (03/2003)

WO 2006/009732 A1 discloses a universal architecture for transport of client signals of a client payload and format type. In particular, the transmission of frames including overhead, payload and FEC is described. Depending on a client signal format or type a pre-determined number of stuff bytes are inserted into digitally wrapped client signals so that the frames with different formats all have the same frame rate no matter what the bit rate of the client signal is. Preferably the stuff bytes are inserted into the payload section of the frames, however, they can also be stuffed into other sections of the signal frame, such as the signal overhead or the FEC section. Their only function is to adjust the size of a frame, and it makes no difference in which section of a frame they are placed. If they are placed in the FEC section, they have no influence on the error correction.

WUTH T. ET AL: "Multi-rate (100G/40G/10G) Transport Over Deployed Optical Networks", PROC., IEEE CONFERENCE ON OPTICAL FIBER COMMUNICATION/NATIONAL FIBER OPTIC ENGINEERS CONFERENCE, OFC/NFOEC 2008, 24 February 2008, pages 1-9, XP031391404, ISBN: 978-1-55752-856-8 describe different scenarios for upgrading existing 10 Gb/s infrastructure to channel date rates of 40 Gb/s and 100 Gb/s is possible by using the ODB, DPSK, RZ-DQPSK and CP-DQPSK transmission schemes, and that an upgrade to 100 Gb/s is possible by using the CP-RZ-DQPSK transmission scheme.

ITU: "SERIES G: TRANSMISSION SYSTEMS AND MEDIA, DIGITAL SYSTEMS AND NETWORKS Digital sections and digital line system - Optical fibre submarine cable systems; Forward error correction for high bit-rate DWDM submarine systems; ITU-T Recommendation G.975.1", ITU-T STANDARD IN FORCE (I), INTERNATIONAL TELECOMMUNICATION UNION, GENEVA, CH, no. G975.11 February 2004 (2004-02-01), pages 1-58, XP002474600, describes Forward Error Correction (FEC) functions that have higher-correction ability than RS(255,239) code defined in ITU-T Rec. G.975 in the optical fibre submarine cable systems. This Recommendation also describes the system requirement concerning supervision for the submarine cable systems. The applications being addressed in this Recommendation are both optically amplified repeatered systems and repeaterless optical systems. The use of this FEC function in submarine terminal transmission equipments should not be considered as mandatory.

MIYATA Y ET AL: "Proposal for frame structure of optical channel transport unit employing LDPC codes for 100 Gb/s FEC", PROC., CONF. ON OPTICAL FIBER COMMUNICATION, OFC 2009, IEEE, PISCATAWAY, NJ, USA, 22 March 2009 (2009-03-22), pages 1-3, XP031467599, ISBN: 978-1-4244-2606-5, proposes an OTU4V frame structure for 100 Gb/s transport system employing concatenated LDPC(9216,7936) + RS(992,956) codes having a Q-limit of 7.1 dB. The compatibility of the OTU4V frame and the proposed codeword length is discussed. It is anticipated that the proposed frame structure with strong FEC codes will open up new vistas for 100 GbE, long distance OTN based transport networks with adequate system margins.

### SUMMARY OF INVENTION

### Technical Problems

The configuration of the conventional error correction method and device is based on the frame configuration having the same information area and the same redundant area. Regarding the transmission rate of an OTUk frame for client signals of different signal types, for example, the OTU4 frame for a 100 Gb/s client signal has a transmission rate of 111.8 Gb/s, which is about 2.6 times a transmission rate of 43.0 Gb/s of the OTU3 frame for a 40 Gb/s client signal. Therefore, for the common use of components of the error correction device, such as an analog/digital converter, a digital/analog converter, and a serializer/de-serializer (SerDes), between processing of both OTU4 and OTU3, it is required to operate a clock generation circuit necessary for those functions, such as a clock multiplier unit (CMU), a phase locked loop (PLL), or a clock-data recovery (CDR), at two kinds of significantly different frequencies. Widening the operating frequency range of the CMU, the CDR, or the PLL thus causes a problem of clock quality degradation such as jitter and transmission performance degradation. The clock quality degradation can be prevented by providing two voltage-controlled oscillators (VCOs) and switching the use of the VCO in accordance with the transmission rate. There has been, however, a problem of an increased circuit scale.

The present invention has been made in order to solve the above-mentioned problems, and it is an object thereof to provide an error correction method and device, which can provide a high-quality and high-speed optical communication system without performance degradation caused by jitter or the like and with the common use of circuits having a reduced circuit scale.

### Solution to Problems

This object according to the invention, is solved by an error correction method comprising the features of claim 1 and an error correction device comprising the features of claim 4, the respectively. Preferred embodiments of this method and this system are defined in the respective dependent claims.

### Advantageous Effects of Invention

According to the present invention, in the FEC frame for storing the client signals of different signal types, the size of the FEC redundant area is adjusted in accordance with the client signals so that the transmission rates of the FEC frame for the respective client signals have an approximately N-multiple relationship (N is a positive natural number). It is therefore possible to provide a high-quality and high-speed optical communication system without performance degradation caused by jitter or the like and with the common use of circuits having a reduced circuit scale.

### BRIEF DESCRIPTION OF DRAWINGS

FIG. 1 is a block diagram illustrating a digital transmission system which is used to describe an error correction method and device according to a first embodiment of the present invention.
FIG. 2 is a block diagram illustrating details of optical transmission devices 1a and 1b illustrated in FIG. 1.
FIG. 3 is a structural diagram illustrating an OTUk frame as specified in ITU-T Recommendation G.709.
FIG. 4(a) illustrates a configuration of a transmission frame (OTU4V frame format) for an output signal of a soft decision FEC encoder 201 and an input signal of a soft decision FEC decoder 206, and FIG. 4(b) illustrates a configuration of a transmission frame (OTU3V frame format) for the output signal of the soft decision FEC encoder 201 and the input signal of the soft decision decoder 206.
FIG. 5 is a block diagram illustrating details of CMUs 207 and 208 illustrated in FIG. 2.
FIGS. 6(a) and 6(b) relate to a second embodiment in which the same hard decision FEC redundant area as that of the OTUk frame is used as an outer code, illustrating configurations of transmission frames corresponding to FIGS. 4(a) and 4(b), respectively.
FIGS. 7 (a) and 7(b) illustrate transmission frames according to a third embodiment, illustrating configurations of transmission frames corresponding to FIGS. 4(a) and 4(b), respectively.
FIGS. 8(a) and 8(b) illustrate transmission frames according to the third embodiment, in which only a soft decision FEC code is used and an FEC redundant area is changed between OTU4V and OTU3V, illustrating configurations of transmission frames corresponding to FIGS. 4(a) and 4(b), respectively.

### DESCRIPTION OF EMBODIMENTS

### First Embodiment

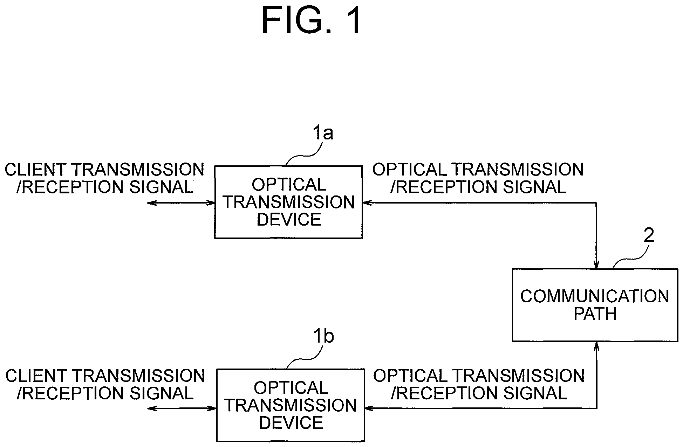

FIG. 1 is a block diagram illustrating a digital transmission system (hereinafter, simply referred to as "transmission system") which is used to describe an error correction method and device according to a first embodiment of the present invention. Optical transmission devices 1a and 1b of FIG. 1 are used for an optical communication system that transmits a transmission frame formed of information data added with an overhead and an error correction code. The optical transmission devices 1a and 1b perform interconversion between a client transmission/reception signal and an optical transmission/reception signal, for example, mapping/demapping between a client signal and an optical transmission frame, error correction coding/decoding, and electrical/optical conversion, thereby performing intercommunication between the optical transmission devices 1a and 1b via a communication path 2.

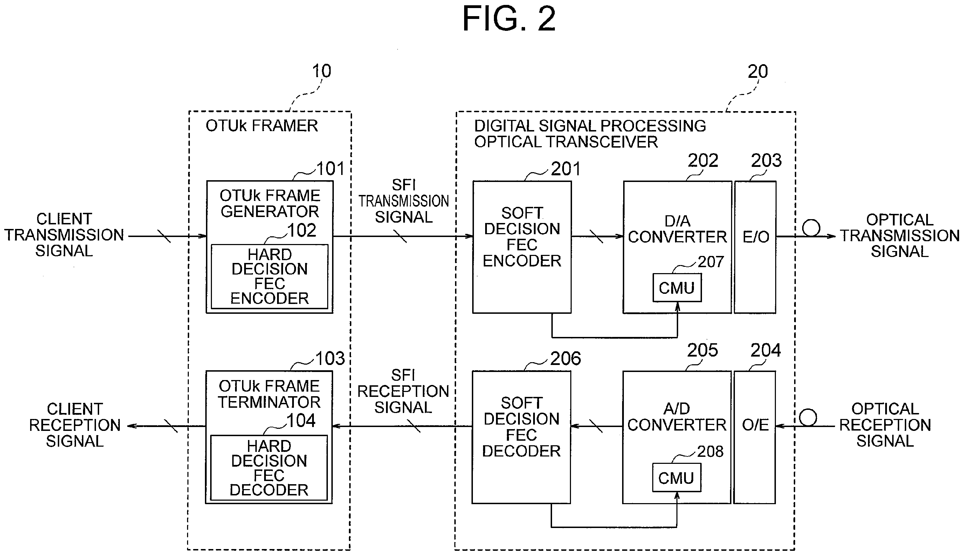

FIG. 2 is a block diagram illustrating details of the optical transmission devices 1a and 1b of FIG. 1. In the optical transmission devices 1a and 1b illustrated in FIG. 2, the size of an FEC redundant area of an FEC frame for storing client signals of different signal types is adjusted in accordance with the client signals so that the relationship (ratio) between the transmission rates of the FEC frame for the respective client signals is adjusted to an approximately N-multiple (N is a positive natural number). In FIG. 2, an optical channel transport unit-k (OTUk) framer 10 includes an OTUk frame generator 101 and an OTUk frame terminator 103. The OTUk frame generator 101 maps a client transmission signal into an OTUk frame and adds information necessary for frame synchronization and maintenance control, to thereby generate an optical transmission frame, and outputs a serdes frame interface (SFI) transmission signal to a digital signal processing optical transceiver 20. The OTUk frame terminator 103 terminates the information necessary for frame synchronization and maintenance control in an SFI reception signal sent from the digital signal processing optical transceiver 20 to thereby demap the client signal from the OTUk frame, and outputs a client reception signal. The OTUk frame generator 101 includes a hard decision FEC encoder 102. The OTUk frame terminator 103 includes a hard decision FEC decoder 104.

The digital signal processing optical transceiver 20 includes a soft decision FEC encoder 201, a digital/analog (D/A) converter 202, an electrical/optical (E/O) 203, an optical/electrical (O/E) 204, an analog/digital (A/D) converter 205, and a soft decision FEC decoder 206. The soft decision FEC encoder 201 encodes the SFI transmission signal sent from the OTUk framer 10 by an error correction code for soft decision. The D/A converter 202 performs D/A conversion on an output signal of the soft decision FEC encoder 201. The E/O 203 converts an analog signal sent from the D/A converter 202 into an optical signal, and outputs an optical transmission signal to the communication path. The O/E 204 converts an optical reception signal sent from the communication path into an analog signal, and outputs the analog signal. The A/D converter 205 converts the analog signal into q-bit soft decision reception data. The soft decision FEC decoder 206 performs soft decision decoding on the soft decision reception data to correct an error, and outputs the SFI reception signal to the OTUk frame 10. The D/A converter 202 includes a CMU 207 for generating a clock corresponding to the transmission rate. The A/D converter 205 includes a CMU 208 for generating a sampling clock corresponding to the transmission rate.

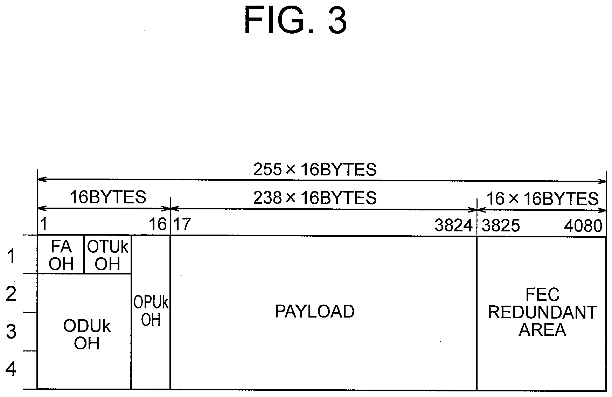

FIG. 3 is a structural diagram illustrating an OTUk frame as specified in ITU-T Recommendation G.709, for example. In FIG. 3, the OTUk frame contains a payload for storing actual communication data such as a client signal, a frame alignment overhead (FA OH) for frame synchronization, an OTUk OH and an optical channel data unit-k overhead (ODUk OH) for maintenance and monitoring information, and an optical channel payload unit-k (OPUk OH) for mapping the payload. The OTUk frame further has an FEC redundant area for storing information on an error correction code for correcting a bit error caused by degradation in optical quality after transmission. A Reed-Solomon code (hereinafter, referred to as RS code) (255,239) is generally used as the error correction code. Note that, a part including the FA OH, the OTUk OH, the ODUk OH, and the OPUk OH is typically called overhead.

In this way, the optical communication system forms a transmission frame by adding the overhead and the error correction code to the payload which is information data to be actually transmitted, and transmits the transmission frame over a long distance at high speed.

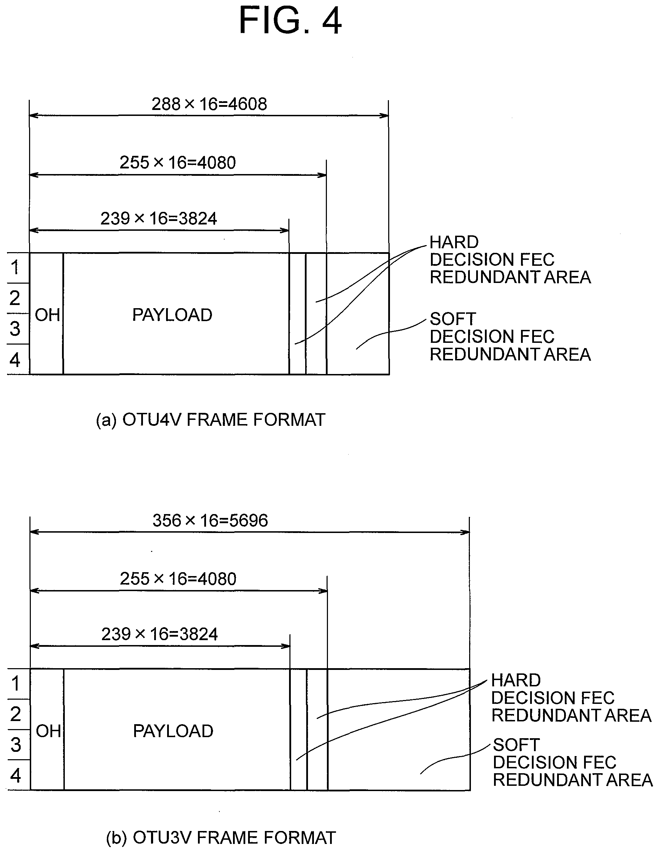

Next, the operation is described with reference to FIGS. 4. FIG. 4(a) illustrates the configuration of a transmission frame for the output signal of the soft decision FEC encoder 201 and the input signal of the soft decision FEC decoder 206, and exemplifies an OTU4V frame having an extended OTU4 for storing, as a client signal, a 100 Gigabit Ethernet (trademark) (hereinafter, referred to as 100 GbE) signal under consideration in IEEE802.3ba. The transmission frame of FIG. 4(a) has the same configuration as that of the OTUk frame illustrated in FIG. 3, but the FEC redundant area is divided into two hard decision FEC redundant areas and a soft decision FEC redundant area is added.

Regarding the transmission frame of FIG. 4(a), the OTUk frame generator 101 first maps a client transmission signal to the payload of FIG. 4(a) and adds various pieces of overhead information to the OH, and the hard decision FEC encoder 102 performs error correction coding as an outer code and stores error correction code information in the hard decision FEC redundant areas. At this time, the hard decision FEC encoder 102 performs concatenated coding by a combination of RS codes and BCH codes, for example, and stores the respective pieces of error correction code information in the two divided FEC redundant areas.

Next, the soft decision FEC encoder 201 performs error correction coding for soft decision decoding as an inner code, such as LDPC coding, and stores error correction code information in the soft decision FEC redundant area. The output signal of the OTU4V frame, which is configured by the soft decision FEC encoder 201, is converted into an analog signal by the D/A converter 202, and is further converted by the E/O 203 into an optical signal to be output to the communication path formed of an optical fiber.

On the reception side, on the other hand, the A/D converter 205 performs analog/digital conversion on the received analog signal whose quality has degraded through the communication path, and outputs q-bit soft decision reception data to the soft decision FEC decoder 206. The soft decision FEC decoder 206 performs soft decision decoding processing with the use of the q-bit soft decision information and the error correction code information of the LDPC code stored in the soft decision FEC redundant area, and outputs the resultant signal to the OTUk frame terminator 103 as an SFI reception signal.

In this case, the transmission rate of the OTU4V frame of FIG. 4(a) is about 126 Mb/s. In the case of using multilevel modulation, such as dual-polarization quadrature phase shift keying (DP-QPSK), the transmission rate is 31.5 Gbaud because of four values. The CMU 207 of the D/A converter 202 and the CMU 208 of the A/D converter 205 generate a 63 GHz clock for double oversampling thereof, for example.

FIG. 4(b) similarly illustrates the configuration of a transmission frame for the output signal of the soft decision FEC encoder 201 and the input signal of the soft decision decoder 206, and exemplifies an OTU3V frame having an extended OTU3 for storing, as a client signal, a 40 Gigabit Ethernet (trademark) (hereinafter, referred to as 40 GbE) under consideration in IEEE802.3ba. The transmission frame of FIG. 4(b) has the same configuration as that of the OTUk frame illustrated in FIG. 3, but the FEC redundant area is divided into two hard decision FEC redundant areas and a soft decision FEC redundant area is added.

The soft decision FEC redundant area of FIG. 4(b) is larger than the soft decision FEC redundant area of FIG. 4(a), and the transmission rate is about 63 Gb/s. While the OTU4V frame format illustrated in FIG. 4(a) has 288·16=4,608 columns in total, the OTU4V frame format illustrated in FIG. 4 (b) has 356·16=5, 696 columns in total. Therefore, for example, in the case of using DP-QPSK modulation, the transmission rate is 15.75 Gbaud, and the CMU 207 of the D/A converter 202 and the CMU 208 of the A/D converter 205 generate a 31.5 GHz clock for double oversampling thereof, for example.

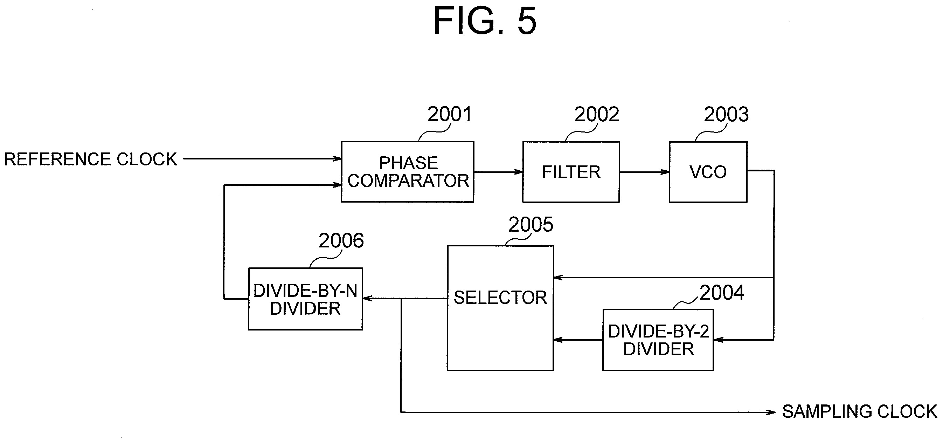

FIG. 5 is a block diagram illustrating details of the CMUs 207 and 208. Each of the CMUs 207 and 208 includes a phase comparator 2001, a filter 2002, a VCO 2003, a divide-by-2 divider 2004, a selector 2005, and a divide-by-N divider 2006. The phase comparator 2001 compares a reference clock sent from the soft decision FEC encoder 201 or the soft decision FEC decoder 206 with a feedback clock sent from the divide-by-N divider 2006. The filter 2002 smooths the comparison result sent from the phase comparator 2001. The VCO 2003 outputs a frequency corresponding to a voltage of the smoothed phase error signal. The divide-by-2 divider 2004 divides the output frequency of the VCO 2003 by 2. The selector 2005 selects one of the clock sent from the VCO 2003 and the clock sent from the divide-by-2 divider 2004, and outputs the selected clock as a sampling clock. The divide-by-N divider 2006 divides the frequency of the sampling clock sent from the selector 2005 by N, and outputs the resultant clock to the phase comparator 2001.

To support OTU4V illustrated in FIG. 4(a), the selector 2005 selects the clock sent from the VCO 2003 and outputs a sampling clock of 63 GHz. To support OTU3V illustrated in FIG. 4(b), on the other hand, the selector 2005 selects the clock sent from the divide-by-2 divider 2004 and outputs a sampling clock of 31.5 GHz.

As described above, through the change of the FEC redundant area in accordance with the client signal to be stored, the transmission rate ratio between OTU4V and OTU3V is adjusted to substantially an integral multiple, and the sampling clock is generated depending on the selection of whether to divide the output frequency of the VCO. Thus, no clock quality degradation such as jitter occurs, which otherwise occurs when the operating frequency range of the VCO is widened greatly, and there is no need to dispose a plurality of VCOs. Thus, the common use of circuits supporting OTU4V and OTU3V becomes possible with a reduced circuit scale.

For example, the soft decision FEC encoder, the soft decision FEC decoder, the D/A converter, and the A/D converter can be formed in a semiconductor integrated circuit so as to be easily shared between OTU4V and OTU3V.

In addition, OTU3V can increase the FEC redundant area, and hence it is possible to improve the coding gain significantly, to thereby increase the transmission distance and increase the capacity owing to multiwavelength.

Note that, the above-mentioned first embodiment has exemplified the soft decision FEC LDPC codes as the inner code, but other soft decision FEC codes, such as convolutional codes and block turbo codes, may be used. Further, the above-mentioned first embodiment has exemplified the concatenated codes of the RS code and the BCH code as the outer code for hard decision FEC, but other concatenated codes, such as concatenated codes of RS and RS and concatenated codes of BCH and BCH, may be used. It should be understood that the use of product codes as the outer code also produces an effect similar to that of the above-mentioned embodiment.

In addition, in the above-mentioned first embodiment, interleaving or deinterleaving may be performed as necessary at the previous stage or the subsequent stage of each error correction coding processing so that an error caused in the transmission path may be dispersed at the time of error correction decoding.

### Second Embodiment

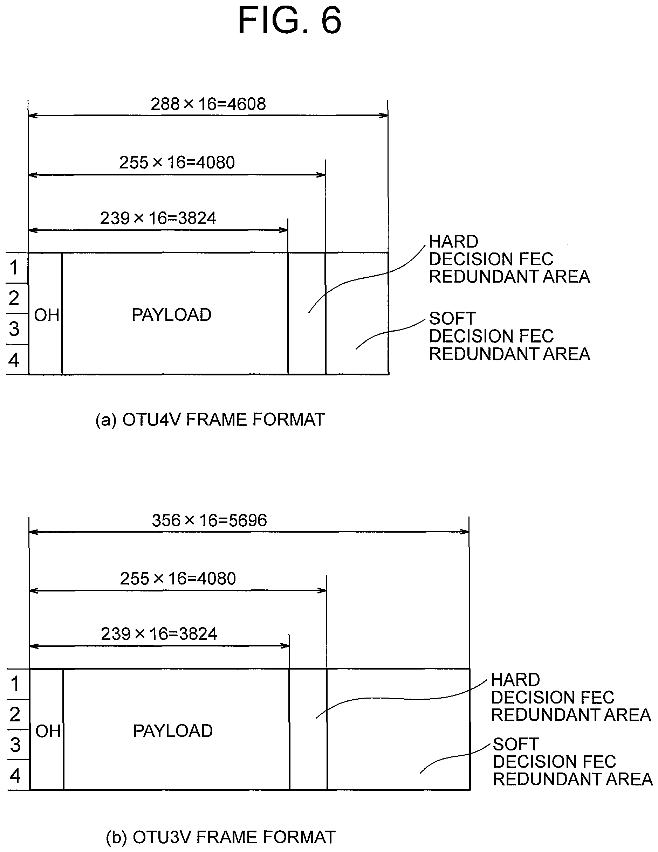

In the first embodiment described above, the hard decision FEC of the outer code uses concatenated codes or product codes. Next, description is given of an embodiment in which the same hard decision FEC redundant area as that of the OTUk frame is used as the outer code as illustrated in FIGS. 6. Examples of the hard decision FEC code include commonly-used RS (255, 239) codes and parent codes of RS(1020, 956) having the increased code length. While the OTU4V frame format illustrated in FIG. 6 (a) has 288·16=4,608 columns in total, the OTU3V frame format illustrated in FIG. 6(b) has 356·16=5,696 columns in total.

Note that, the second embodiment has exemplified the RS codes as the outer code, but the outer code may be BCH codes or other codes.

### Third Embodiment

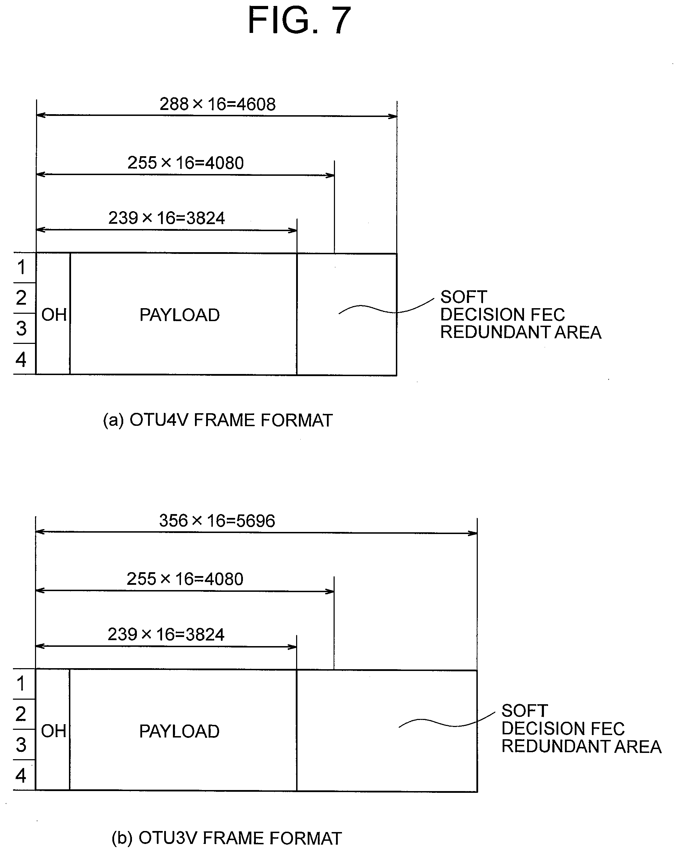

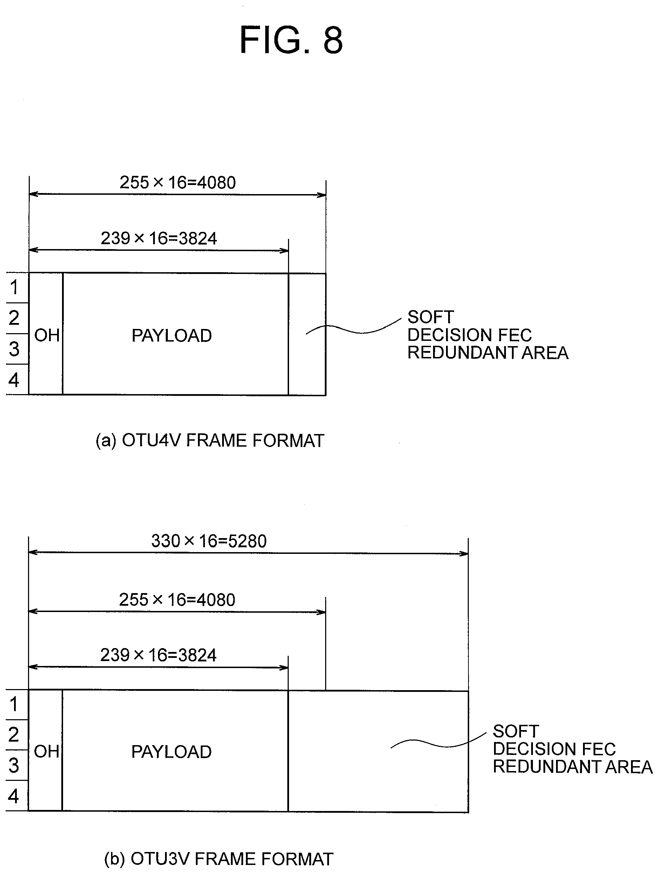

In the second embodiment described above, the hard decision FEC of the outer code uses the RS codes or the like, and the FEC redundant area of the OTUk frame stores coded information on the outer code. Next, description is given of a configuration as illustrated in FIGS. 7 and 8 in which only the soft decision FEC code is used and the FEC redundant area is changed between OTU4V and OTU3V. It should be understood that the use of only the hard decision FEC code also produces a similar effect.

While the OTU4V frame format illustrated in FIG. 7(a) has 288·16=4,608 columns in total, the OTU3V frame format illustrated in FIG. 7 (b) has 356·16=5, 696 columns. While the OTU4V frame format illustrated in FIG. 8(a) has 255·16=4,080 columns in total, the OTU3V frame format illustrated in FIG. 8(b) has 330·16=5,280 columns.

### Fourth Embodiment

In the embodiments described above, the frame contains the OH, the payload, and the FEC redundant area. It should be understood, however, that the use of a frame added with another area unrelated to error correction, such as a training area, also produces a similar effect.

### Reference Signs List

1a, 1b optical transmission device, 2 communication path, 10 OTUk framer, 20 digital signal processing optical transceiver, 101 OTUk frame generator, 102 hard decision FEC encoder, 103 OTUk frame terminator, 104 hard decision FEC decoder, 201 soft decision FEC encoder, 202 D/A converter, 203 E/O, 204 O/E, 205 A/D converter, 206 soft decision FEC decoder, 207, 208 CMU, 2001 phase comparator, 2002 filter, 2003 VCO, 2004 divide-by-2 divider, 2005 selector, 2006 divide-by-N divider.

## Claims

1. An error correction method for an optical communication system for 40 Gbit/s and 100 Gbit/s client signals that transmits an FEC frame as an OTU3V or OTU4V transmission frame formed of information data added with an overhead and added with coded information as information on an error correction code, the error correction method comprises
adjusting the size of an FEC redundant area of the FEC frame, where the FEC redundant area stores the coded information as the information on the error correction code of the FEC frame and the FEC frame stores the client signal of the OTU3V transmission frame or the OTU4V transmission frame, according to whether a frame format of the client signals is the OTU4V transmission frame or the OTU3V transmission frame so that a first transmission rate of the FEC frame for the client signals of the OTU4V transmission frame is N times a second transmission rate of the FEC frame for the client signals of the OTU3V transmission frame, N being a non-zero natural number, and using an increase of the FEC redundant area of the OTU3V transmission frame compared to the OTU4V transmission frame for improving the coding gain.

2. The error correction method according to claim 1, wherein the OTU4V transmission frame has 4,608 columns and the OTU3V transmission frame has 5,696 columns.

3. The error correction method according to claim 1, wherein the OTU4V transmission frame has 4,080 columns and the OTU3V transmission frame has 5,280 columns.

4. An error correction device for an optical communication system for 40 Gbit/s and 100 Gbit/s client signals that transmits an FEC frame as an OTU3V or OTU4V transmission frame formed of information data added with an overhead and added with coded information as information on an error correction code, the error correction device comprising:
an optical transmission framer (10) for generating the OTU3V or OTU4V transmission frame based on mapping of the client signal into the OTU3V or OTU4V transmission frame and outputting a transmission signal, and for demapping the client signal from the OTU3V or OTU4V transmission frame based on an input of a reception signal and outputting a client reception signal;
an FEC encoder (201) for encoding the transmission signal sent from the optical transmission framer (10) by the error correction code;
a D/A converter (202) for performing D/A conversion on an output signal of the FEC encoder (201) and outputting an optical transmission signal to a communication path;
an A/D converter (205) for converting an optical reception signal sent from the communication path into a digital signal; and
an FEC decoder (206) for decoding reception data from an output of the A/D converter (205) to correct an error, and outputting the reception signal to the optical transmission framer (10),
wherein each of the D/A converter (202) and the A/D converter (205) comprises clock generation means (207, 208) for changing a sampling clock in accordance with client signals, and
the error correction device adjusts the size of an FEC redundant area of the FEC frame, where the FEC redundant area stores the coded information as the information on the error correction code and the FEC frame stores the client signals of the OTU3V or OTU4V transmission frame, wherein the size of the FEC redundant area is adjusted according to whether a frame format of the client signals is the OTU4V transmission frame or the OTU3V transmission frame so that a transmission rate of the FEC frame for the client signals of the OTU4V transmission frame is N times a second transmission rate of the FEC frame for the client signals of the OTU3V transmission frame, N being a non-zero natural number, and the error correction device uses an increase of the FEC redundant area of the OTU3V transmission frame compared to the OTU4V transmission frame for improving the coding gain.

5. The error correction device according to claim 4, wherein the clock generation means (207, 208) comprises:
a phase comparator (2001) for comparing a reference clock sent from the FEC encoder (201) or the FEC decoder (206) with a feedback clock;
a filter (2002) for smoothing a comparison result sent from the phase comparator (2001);
a VCO (2003) for outputting a frequency corresponding to a voltage of a smoothed phase error signal;
a divide-by-2 divider (2004) for dividing the output frequency of the VCO (2003) by 2;
a selector (2005) for selecting one of a clock sent from the VCO (2003) and a clock sent from the divide-by-2 divider (2004) in accordance with the client signal, and outputting the selected clock as a sampling clock; and
a divide-by-N divider (2006) for dividing a frequency of the sampling clock sent from the selector (2005) by N, and outputting the feedback clock to the phase comparator (2001).

## Patentansprüche

1. Fehlerkorrekturverfahren für ein optisches Kommunikationssystem für 40 Gbit/s- und 100 Gbit/s-Kundensignale, das einen FEC-Rahmen als einen OTU3V- oder OTU4V-Übertragungsrahmen überträgt, der aus Informationsdaten, denen ein Kopfteil und codierte Informationen als Informationen über einen Fehlerkorrekturcode hinzugefügt sind, gebildet ist, welches Fehlerkorrekturverfahren aufweist:
Einstellen der Größe eines FEC-Redundanzbereichs des FEC-Rahmens, wobei der FEC-Redundanzbereich die codierten Informationen als die Informationen über den Fehlerkorrekturcode des FEC-Rahmens speichert und der FEC-Rahmen das Kundensignal des OTU3V-Übertragungsrahmens oder des OTU4V-Übertragungsrahmens speichert, gemäß denen ein Rahmenformat der Kundensignale der OTU4V-Übertragungsrahmen oder der OTU3V-Übertragungsrahmen ist, so dass eine erste Übertragungsrate des FEC-Rahmens für die Kundensignale des OTU4V-Übertragungsrahmens das N-fache einer zweiten Übertragungsrate des FEC-Rahmens für die Kundensignale des OTU3V-Übertragungsrahmens ist, wobei N eine von null verschiedene natürliche Zahl ist, und Verwenden einer Vergrößerung des FEC-Redundanzbereichs des OTU3V-Übertragungsrahmens im Vergleich zu dem OTU4V-Übertragungsrahmen zur Verbesserung des Codiergewinns.

2. Fehlerkorrekturverfahren nach Anspruch 1, bei dem der OTU4V-Übertragungsrahmen 4.608 Spalten hat und der OTU3V-Übertragungsrahmen 5.696 Spalten hat.

3. Fehlerkorrekturverfahren nach Anspruch 1, bei dem der OTU4V-Übertragungsrahmen 4.080 Spalten hat und der OTU3V-Übertragungsrahmen 5.280 Spalten hat.

4. Fehlerkorrekturvorrichtung für ein optisches Kommunikationssystem für 40 Gbit/s- und 100 Gbit/s-Kundensignale, das einen FEC-Rahmen als einen OTU3V- oder OTU4V-Übertragungsrahmen überträgt, der aus Informationsdaten, denen ein Kopfteil und kodierte Informationen als Informationen über einen Fehlerkorrekturcode hinzugefügt sind, gebildet ist,
welche Fehlerkorrekturvorrichtung aufweist:
eine Vorrichtung (10) zum Bilden eines optischen Übertragungsrahmens für die Erzeugung des OTU3V- oder OtU4V-Übertragungsrahmens auf der Grundlage des Abbildens des Kundensignals in den OTU3V- oder OTU4V-Übertragungsrahmen, und Ausgeben eines Übertragungssignals, und zum Rückabbilden des Kundensignals aus dem OTU3V- oder OTU4V-Übertragungsrahmen auf der Grundlage einer Eingabe eines Empfangssignals, und Ausgeben eines Kundenempfangssignals;
einen FEC-Codierer (201) zum Codieren des von der Vorrichtung (10) zum Bilden des optischen Übertragungsrahmens gesendeten Übertragungssignals durch den Fehlerkorrekturcode;
einen D/A-Wandler (202) zum Durchführen einer D/A-Umwandlung eines Ausgangssignals des FEC-Codierers (201) und Ausgeben eines optischen Übertragungssignals zu einem Kommunikationspfad;
einen A/D-Wandler (205) zum Umwandeln eines optischen Empfangssignals, das von dem Kommunikationspfad gesendet wurde, in ein digitales Signal; und
einen FEC-Decodierer (206) zum Decodieren von Empfangsdaten von einem Ausgang des A/D-Wandlers (205), um einen Fehler zu korrigieren, und zum Ausgeben des Empfangssignals zu der Vorrichtung (10) zum Bilden eines optischen Übertragungsrahmens,
wobei jeder der D/A-Wandler (202) und der A/D-Wandler (205) Takterzeugungsmittel (207, 208) zum Ändern eines Abtasttakts gemäß den Kundensignalen aufweist, und
die Fehlerkorrekturvorrichtung die Größe eines FEC-Redundanzbereichs des FEC-Rahmens einstellt, wobei der FEC-Redundanzbereich die codierten Informationen als die Informationen über den Fehlerkorrekturcode speichert, und der FEC-Rahmen die Kundensignale des OTU3V- oder OTU4V-Übertragungsrahmens speichert,
wobei die Größe des FEC-Redundanzbereichs eingestellt wird in Abhängigkeit davon, ob ein Rahmenformat der Kundensignale der OTU4V-Übertragungsrahmen oder der OTU3V-Übertragungsrahmen ist, so dass eine Übertragungsrate des FEC-Rahmens für die Kundensignale des OTU4V-Übertragungsrahmens das N-fache einer zweiten Übertragungsrate des FEC-Rahmens für die Kundensignale des OTU3V-Übertragungsrahmens ist, wobei N eine von null verschiedene natürliche Zahl ist,
und die Fehlerkorrekturvorrichtung eine Vergrößerung des FEC-Redundanzbereichs des OTU3V-Übertragungsrahmens im Vergleich zu dem OTU4V-Übertragungsrahmen zur Verbesserung des Codiergewinns verwendet.

5. Fehlerkorrekturvorrichtung nach Anspruch 4, bei der die Takterzeugungsmittel (207, 208) aufweisen:
einen Phasenkomparator (2001) zum Vergleichen eines von dem FEC-Codierer (201) oder dem FEC-Decodierer (206) gesendeten Bezugstakts mit einem Rückkopplungstakt;
ein Filter (2002) zum Glätten eines von dem Phasenkomparator (2001) gesendeten Vergleichsergebnisses ;
einen VCO (2003) zum Ausgeben einer Frequenz entsprechend einer Spannung eines geglätteten Phasenfehlersignals;
einen Teiler (2004) zum Teilen durch 2 für die Teilung der Ausgangsfrequenz des VCO (2003) durch 2;
eine Auswahlvorrichtung (2005) zum Auswählen eines von einem Takt, der von dem VCO (2003) gesendet wurde, und einem Takt, der von dem Teiler (2004) zum Teilen durch 2 gesendet wurde, gemäß dem Kundensignal, und zum Ausgeben des ausgewählten Takts als einen Abtasttakt; und
einen Teiler (2006) zum Teilen durch N für die Teilung einer Frequenz des von der Auswahlvorrichtung (2005) gesendeten Abtasttakts durch N, und für das Ausgeben des Rückkopplungstakts zu dem Phasenkomparator (2001).

## Revendications

1. Procédé de correction d'erreurs d'un système de communication optique de signaux client à 40 Gbit / s et 100 à Gbit / s, qui transmet une trame FEC en tant que trame de transmission OUT3V ou OUT4V constituée de données d'informations auxquelles ont été ajoutés un surdébit et des informations codées en tant qu'informations qui se rapportent à un code de correction d'erreurs, le procédé de correction d'erreurs comprenant les étapes consistant à :
régler la taille d'une zone redondante FEC de la trame FEC, dans lequel la zone redondante FEC stocke les informations codées en tant qu'informations qui se rapportent au code de correction d'erreurs de la trame FEC, et la trame FEC stocke le signal client de la trame de transmission OUT3V ou de la trame de transmission OUT4V, selon le fait qu'un format de trame des signaux client est la trame de transmission OUT4V ou la trame de transmission OUT3V, de telle sorte qu'un premier débit de transmission de la trame FEC des signaux client de la trame de transmission OUT4V, soit égal à N fois un second débit de transmission de la trame FEC des signaux client de la trame de transmission OUT3V, N étant un nombre entier naturel différent de zéro, et utiliser une augmentation de la zone redondante FEC de la trame de transmission OUT3V en comparaison de la trame de transmission OUT4V de façon à améliorer le gain de codage.

2. Procédé de correction d'erreurs selon la revendication 1, dans lequel la trame de transmission OUT4V présente 4608 colonnes et la trame de transmission OUT3V présente 5696 colonnes.

3. Procédé de correction d'erreurs selon la revendication 1, dans lequel la trame de transmission OUT4V présente 4 080 colonnes et la trame de transmission OUT3V présente 5 280 colonnes.

4. Dispositif de correction d'erreurs d'un système de communication optique de signaux client à 40 Gbit / s et 100 à Gbit / s, qui transmet une trame FEC en tant que trame de transmission OUT3V ou OUT4V constituée de données d'informations auxquelles ont été ajoutés un surdébit et des informations codées en tant qu'informations qui se rapportent à un code de correction d'erreurs, le dispositif de correction d'erreurs comprenant :
un dispositif de mise en trame de transmission optique (10) destiné à générer la trame de transmission OUT3V ou OUT4V sur la base d'un mappage du signal client vers la trame de transmission OUT3V ou OUT4V, et à délivrer en sortie un signal de transmission, et à démapper le signal client à partir de la trame de transmission OUT3V ou OUT4V sur la base d'une entrée d'un signal de réception, et à délivrer en sortie un signal de réception client ;
un codeur FEC (201) destiné à coder le signal de transmission envoyé par le dispositif de mise en trame de transmission optique (10) avec le code de correction d'erreurs ;
un convertisseur D / A (202) destiné à exécuter une conversion D / A sur un signal de sortie du codeur FEC (201), et à délivrer en sortie un signal de transmission optique vers un chemin de communication ;
un convertisseur A / D (205) destiné à convertir un signal de réception optique envoyé par le chemin de communication en un signal numérique ; et
un décodeur FEC (206) destiné à décoder les données de réception en provenance d'une sortie du convertisseur A / D (205) de façon à corriger une erreur, et à délivrer en sortie le signal de réception au dispositif de mise en trame de transmission optique (10) ;
dans lequel chacun du convertisseur D / A (202) et du convertisseur A / D (205) comprend des moyens de génération d'horloge (207, 208) destinés à modifier une horloge d'échantillonnage selon les signaux client, et le dispositif de correction d'erreurs règle la taille d'une zone redondante FEC de la trame FEC, dans lequel la zone redondante FEC stocke les informations codées en tant qu'informations qui se rapportent au code de correction d'erreurs, et la trame FEC stocke les signaux client de la trame de transmission OUT3V ou OUT4V ;
dans lequel la taille de la zone redondante FEC est réglée selon le fait qu'un format de trame des signaux client est la trame de transmission OUT4V ou la trame de transmission OUT3V, de telle sorte que le débit de transmission de la trame FEC des signaux client de la trame de transmission OUT4V, soit égal à N fois le second débit de transmission de la trame FEC des signaux client de la trame de transmission OUT3V, N étant un nombre entier naturel différent de zéro ;
et le dispositif de correction d'erreurs utilise une augmentation de la zone redondante FEC de la trame de transmission OUT3V en comparaison de la trame de transmission OUT4V de façon à améliorer le gain de codage.

5. Dispositif de correction d'erreurs selon la revendication 4, dans lequel les moyens de génération d'horloge (207, 208) comprennent :
un comparateur de phase (2001) destiné à comparer une horloge de référence envoyée par le codeur FEC (201) ou le décodeur FEC (206) avec une horloge de rétroaction ;
un filtre (2002) destiné à lisser un résultat de comparaison envoyé par le comparateur de phase (2001) ;
un VCO (2003) destiné à délivrer en sortie une fréquence qui correspond à une tension d'un signal d'erreur de phase lissé ;
un diviseur par 2 (2004) destiné à diviser par 2 la fréquence de sortie du VCO (2003) ;
un dispositif de sélection (2005) destiné à sélectionner l'une d'une horloge envoyée par le VCO (2003), et d'une horloge envoyée par le diviseur par 2 (2004) selon le signal client, et à délivrer en sortie l'horloge sélectionnée en tant qu'horloge d'échantillonnage ; et
un diviseur par N (2006) destiné à diviser par N la fréquence de l'horloge d'échantillonnage envoyée par le dispositif de sélection (2005), et à délivrer en sortie l'horloge de rétroaction au comparateur de phase (2001).
